# EUROPEAN PATENT SPECIFICATION

(11) **EP 2 345 904 B1**
(45) Date of publication and mention of the grant of the patent: **26.09.2012**
(21) Application number: 10000162.7
(22) Date of filing: 11.01.2010
(51) Int. Cl.: G01R 31/36

(54) **Battery management system**
System zur Batterieverwaltung
Système de gestion de batterie

(43) Date of publication of application: 20.07.2011
(73) Proprietor: Coronis SAS, 34470 Perols (FR)
(72) Inventor: Dupont, Vincent, 30260 Gailhan (FR)
(74) Representative: Bentz, Jean-Paul

(56) References cited:
- EP-A2- 1 482 318
- US-B1- 6 433 513

## Description

### DOMAIN OF THE INVENTION

The present invention relates to a battery management system for providing reliable information on battery level of a device having low power consumption issues.

The invention relates to the technical field of the battery management systems. More particularly, the invention relates to battery management systems used in automatic meter reading environments, specially in the case of networks based on low battery powered devices.

The invention is also applicable, but not limited to automotive, environmental and long-range ultra high frequency (UHF) radio frequency identification (RFID) applications.

### BACKGROUND OF THE INVENTION

It is known from the prior art, devices embed battery monitoring systems. EP 1 482 318 A2 discloses a battery monitor using a life counter value representing the remaining available life of the battery being monitored. An efficient method is based on power level measurement comprising specific algorithms for non-linear curve compensation. Power management based on battery level measurement gives information on battery status and is generally used to draw a pictogram, such as that which is common on cellular phone displays. This system is only reliable to a limited number of battery types, lithium batteries are not easily measurable, and the level variation cannot be linked to actual remaining energy capacity.

Some efficient algorithms can compensate non-linear curves but it is a complex matter to manage aging on a device that has a 10 year guarantee on battery life. Indeed, the internal resistor of a battery can vary in temperature and introduce measurement errors.

Therefore, lithium batteries are unsuitable for voltage measurement, in particular during passivity. Measurement cannot be efficient for long-life duration, and can actually cause problems for product guarantees.

### SUMMARY OF THE INVENTION

An object of the invention is to overcome the disadvantages of the prior art by improving the reliability of battery management systems installed on devices having long life spans.

It is another object of the invention to realize a battery management system being controllable by after-sales services to identify production problems or other mistakes that can affect the initial battery capacity, as well as hardware mistakes that can cause over-consumption on a given target.

Therefore, the battery management system of the invention is based on event monitoring used to decrement a global life counter according to predetermined consumptions linked to specific application activities.

More particularly, the invention concerns a battery management system as defined in claim 1.

The event monitoring unit comprises event counters of the application activities of the device.

Preferably, the event monitoring unit is linked to a communication device apt to emit an alert radio frame when the overall life counter gets inferior to a critical standard.

Advantageously, the battery management system comprises a sensing device linked to the event monitoring unit in order to adapt the specific event consumption values according to the ambient physical conditions.

The invention also concerns a radio communication device comprising a battery management system according to the invention.

An advantage of the invention is to increase the reliability of the battery management system without being dependant of the spoiling of the system due to non linear-curves compensation.

Another advantage of the invention is the logging of the consumption profile and its use in after-sales services. Various levels of fine-tuning with this system can make it possible to estimate the remaining amount of energy reliably.

The invention also allows the monitoring of production problems, and other mistakes, that can affect the initial battery capacity, as well as hardware mistakes that can cause over-consumption on a given target. With the battery counter, this problem can be seen directly by after-sale service technicians, and it is easy to use. When battery errors are suspected, they may be acknowledged or dismissed rapidly via immediate diagnostics. It is then possible to remove or to reduce the external phenomena that impact the average consumption.

### BRIEF DESCRIPTION OF THE DRAWINGS

The device and method according to the invention are hereinafter described in detail, underlining the advantages they exhibit compared to the prior art, with reference to attached drawing :
- Figure 1 is a schematic diagram of a battery management system according to the invention ;
- Figure 2 is a flowchart of a battery management method according to the invention ;

### DECRIPTION OF PREFERRED EMBODIMENTS OF THE INVENTION

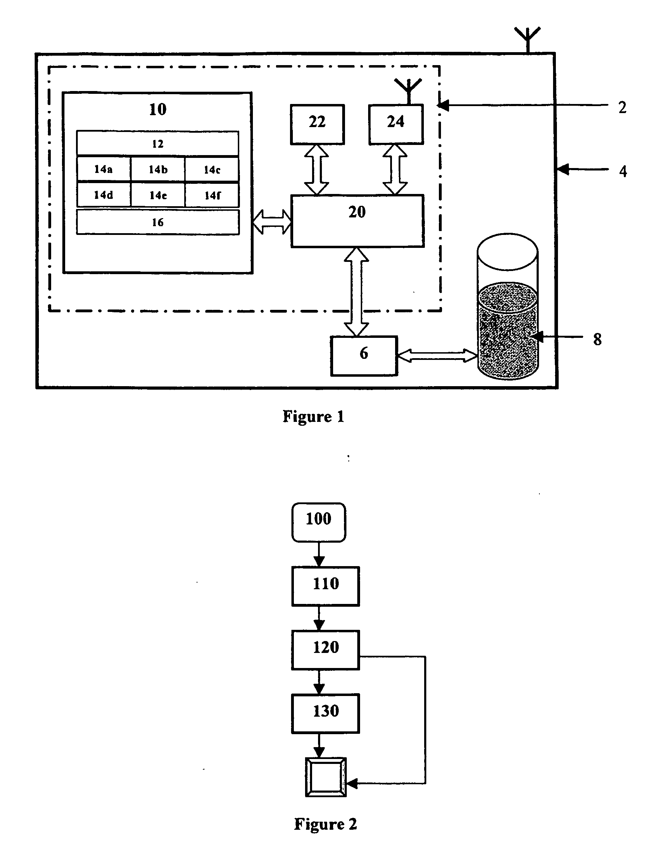

Figure 1 represents a battery management system 2 incorporated inside a radio-communication device 4 such as a meter reading system. This radio-communication device 4 comprises a processing unit 6 feed with a battery 8, such as a LS17500 provided by the manufacturer SAFTL, having a capacity of 3.3 Amps for one hour use.

Alternately, the device 4 could be other automotive, environmental or long-range UHF RFID applications.

The battery management system 2 comprises a non-volatile memory 10 that stores a predetermined overall life counter 12 containing some elementary consumption unities whose sum corresponds to the lifespan of the battery 8.

The non volatile memory 10 also stores the number of elementary consumption unities, called event consumption value 14a to 14e, that correspond to the consumption of the battery 8 used by an application activity of the device 4. For example, such event consumption value can correspond to : an average consumption linked to specific application activities, a periodic radio scanning, a reception of a radio request, an emission of a response radio frame, a periodic VCO calibration, a reception of a valid radio acknowledgement, a reception of an invalid radio acknowledgement, a reception of a valid radio response, a reception of an invalid radio response, an emission of a request frame, an emission of an acknowledgement, etc.

Moreover, the non volatile memory 10 stores a critical standard 16 corresponding to the minimum number of elementary consumption unities that can remain in the overall life counter 12 before the launch of an alert proceeding 18. An event monitoring unit 20 linked to the processing unit 6 of the device 4 communicates with said non volatile memory 10. According to an other embodiment, the event monitoring unit 20 could be include in the processing unit 6 of the device 4.

Advantageously, the event monitoring unit 20 also comprises a plurality of event counters related to each application activity of the device 4. Therefore, when the event monitoring unit 20 receives application activity data from the processing unit 6 of the device 4, the corresponding event counter is incremented and the corresponding event consumption value 14a to 14e, stored in the non volatile memory 10, is identified.

Then, for each application activity of the device 4, the event monitoring unit 20 decrements the corresponding event consumption value 14a to 14e from the overall life counter 12.

Advantageously, the battery management system comprises a sensing device 22, such as a temperature or a pressure sensor, linked to the event monitoring unit 20. Thus, the event consumption value 14a to 14e corresponding to each application activity of the device 4 is adapted according to ambient physical conditions (temperature, pressure, hygrometry, etc.) around the device 4. Indeed, it is known that the consumption of batteries is dependant upon ambient physical conditions such as the temperature.

Preferably, when the overall life counter 12 gets inferior to a critical standard 16, the event monitoring unit 20 emits an alert frame signal, through a communication unit 24, to notify the customer about the low remaining power level of its device's 4 battery 8. The communication unit 24 may also allow to read or write information related to the even counters.

Advantageously, the battery management system 20 also comprises a calculation system, linked to the non volatile memory 10 and more particularly to the overall life counter 12, that allows to estimate the remaining lifespan of the device's 4 battery 8 according to its usual use and to the remaining overall life counter 12.

A flowchart of the task of decreasing 100 the overall life counter 12 stored in the non volatile memory 10 is represented on figure 3. A first step 110 consists in decrementing the specific event consumption value, corresponding to an application activity of the device 4, from the overall life counter 12. A second step 120 consists in verifying that the overall life counter 12 is still higher than a predetermined critical value. If it is, than the task ends. If not, a third step 130 is to send an alarm frame so that the customer is informed that the remaining power level of the battery is low. Therefore, the device 4 can be replace before it gets unusable.

According to one embodiment of the invention, the device 4 is a water meter monitoring device that detects pulses on its input to count the quantity of water consumed by a given customer and therefore samples all pulse input lines with a frequency determined by a predefined parameter value.

A first phase to implement the invention is to determine the consumption induced by each application activity of the device. The following application activities may be implemented a battery management system according to the invention.

### Average consumption value

For example, the battery management system 2 may take into account the static currents that exists in said device 4 during specific application activities. The following table 1 shows the static current according to predefined application activities :

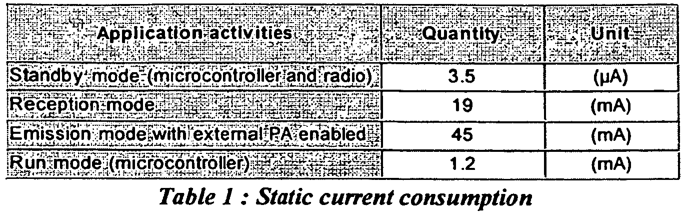

Average power consumption depends on pull up resistors used on each line and on the sampling frequency. The following table 2 shows the consumption based on these two factors.

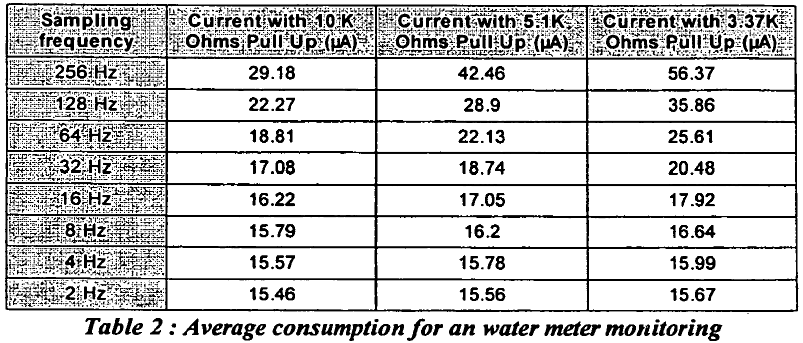

### Periodic wake-up mode

Some application activities can have a strong impact on the average current consumption. For example, periodic radio scans resulting in unnecessary wake-up detections increase significantly the average consumption. A large number of devices 4 generally use a periodic wake-up mode as a technique to estimate the average current consumption. Some of them contain algorithm for noise threshold auto-adaptation in order to achieve a maximum predefined number of incorrect wake-ups, for example 3%. Therefore, the battery management system 2 also take into account the periodic radio scans resulting in unnecessary wake-up detections.

The following tables 3 and 4 consider the previous value given in the static current consumption table 1 and exhibit the average consumption for periodic scanning and for incorrect wake-up.

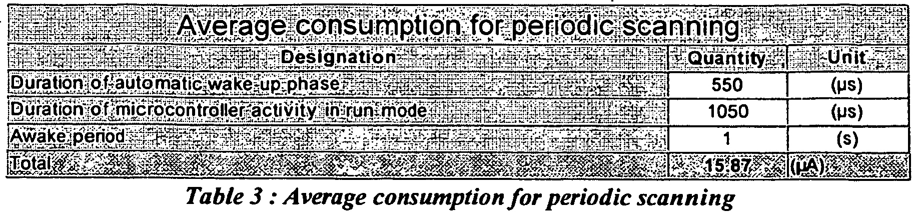

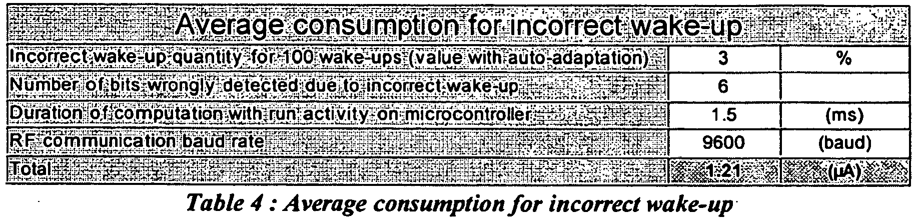

Therefore, each day the event monitoring device 20 decrements the correct event consumption value, corresponding to its configuration, from the overall life counter 12 to be counted as a daily consumption. Eventually, the event monitoring unit also takes into account the average consumption for incorrect wake-up

### Calculation for frame reception

In this embodiment, the device 4 wakes up once every second, performing a radio scan to detect a wake-up preamble equal to 1100ms. The time duration to receive a wake-up preamble varies depending on when the device 4 performs reception. The time needed to detect the wake-up preamble is 600 ms on average. Furthermore, according to this embodiment, most request frames dedicated to a radio module contain one block of 32 data bytes. A requester device generally sends a low number of bytes (1 to 6 command bytes).

Two blocks will be considered for this calculation, as all decoded frames are not necessarily dedicated to the device 4, and several types of frame with varying quantities of bytes can be received over the air. For this consumption aspect, radio reception activity is counted by the radio-communication device 4.

Thus, the processing unit 6 of this device 4 is linked to the event monitoring device 20 in order to inform it for each reception activity. Then, the overall life counter 12 is dynamically decremented of the corresponding event consumption value by the event monitoring unit 20, according to the number of occurrences.

The following table 5 exhibits the average consumption for a periodic frame reception, with a number of frames received per day equal to 50.

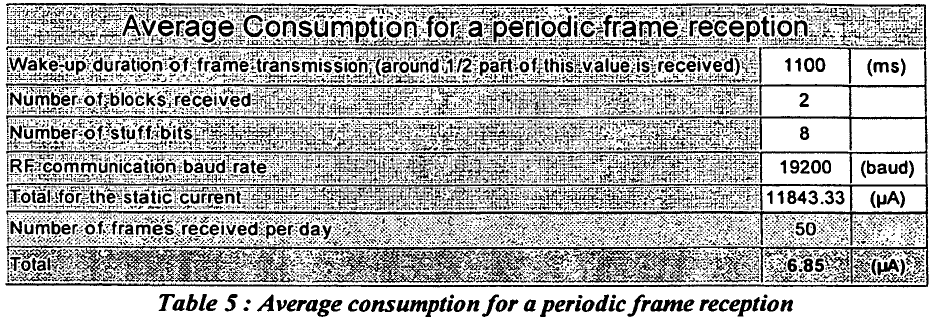

### Calculation for frame emission

Regarding the current utilization of the device 4, the average number of blocks transmitted in a frame is generally equal to 8 data blocks of 32 data bytes. In the same way, the processing unit 6 of the device 4 is linked to the event monitoring device 20 in order to inform it for each emission activity. Then, the overall life counter 12 is dynamically decremented of an event consumption value by the event monitoring unit 20, according to the number of occurrences.

The following table 6 exhibits the average consumption for a periodic frame emission, with a number of frames sent per day equal to 3.

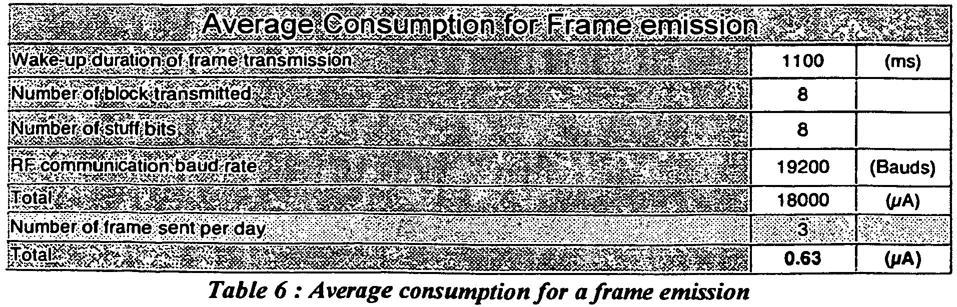

### Constant value by events:

With respect to the consumption values previously calculated, a second phase consist in finding the corresponding number of elementary consumption unities, corresponding to the event consumption values 14a to 14e, that will be decremented from the overall life counter 12.

Each event counter included in the event monitoring unit 20 increases after detecting a linked event. The corresponding event consumption value is, then, decremented from the overall life counter when an overflow occurs on the event counter. All event counters embedded in the event monitoring unit 20 are accessible through a specific radio command of the communication device 24 for reading or writing parameters. This way, it is possible for a user to read the status of the consumption profile at any time. This information is useful for determining the consumption profile and for determining if the guarantee conditions are respected.

Although the present invention has been described in connection with preferred embodiments thereof, it will be appreciated by those skilled in the art that additions, deletions, modifications, and substitutions not specifically described may be made without departing from the spirit and the scope of the invention as defined in the appended claims.

Thus, even if the described embodiments point at battery management systems which are located inside the radio-communication device, it could also be possible to manage the battery management system externally, in a network. For example, the event monitoring unit 16 could be located outside the radio-communication device 4 and communicate wirelessly with it.

## Claims

1. Battery management system adapted to provide information on battery level of a device (4), comprising a non-volatile memory (10), the non-volatile memory (10) is adapted to store a predetermined overall life counter (12) and is linked to an event monitoring unit (20) **characterised in that** the event monitoring unit comprises a plurality of event counters related to each application activity of the said device (4), the said event monitoring unit (20) being adapted to decrement the overall life counter (12) of a specific event consumption value (14a to 14e) for each event corresponding to an application activity of the device (4)

2. Battery management system according to claim 1, wherein the event counters are incremented after detection of a linked event.

3. Battery management system according to claim 1 or 2, wherein the event monitoring unit (20) is linked to a communication device (24) being adapted to emit an alert radio frame when the overall life counter (12) gets inferior to a critical standard (16).

4. Battery management system according to any of claims 1 to 3, comprising a sensing device (22) linked to the event monitoring unit (20) in order to adapt the specific event consumption values (14a to 14e) according to the ambient physical conditions.

5. Radio communication device comprising a battery management system according to any of claims 1 to 4.

## Patentansprüche

1. Batteriemanagementsystem, das dafür ausgelegt ist, Informationen über einen Batteriestand eines Geräts (4) bereitzustellen, mit einem nichtflüchtigem Speicher (10), wobei der nichtflüchtige Speicher (10) dafür ausgelegt ist, einen vorbestimmten Gesamt-Lebensdauerzähler (12) zu speichern und mit einer Ereignisüberwachungseinheit (20) verbunden ist, **dadurch gekennzeichnet, dass** die Ereignisüberwachungseinheit mehrere Ereigniszähler in Bezug auf jede Anwendungsaktivität des Geräts (4) umfasst, wobei die Ereignisüberwachungseinheit (20) dafür ausgelegt ist, den Gesamt-Lebensdauerzähler (12) eines spezifischen Ereignisverbrauchswerts (14a-14e) für jedes Ereignis zu dekrementieren, das einer Anwendungsaktivität des Geräts (4) entspricht.

2. Batteriemanagementsystem nach Anspruch 1, wobei die Ereigniszähler nach der Detektion eines verbundenen Ereignisses inkrementiert werden.

3. Batteriemanagementsystem nach Anspruch 1 oder 2, wobei die Ereignisüberwachungseinheit (20) mit einem Kommunikationsgerät (24) verbunden ist, das dafür ausgelegt ist, einen Hinweisfunkrahmen zu emittieren, wenn der Gesamt-Lebensdauerzähler (12) kleiner als ein kritischer Standard (16) wird.

4. Batteriemanagementsystem nach einem der Ansprüche 1 bis 3, das eine Erfassungseinrichtung (22) umfasst, die mit der Ereignisüberwachungseinheit (20) verbunden ist, um die spezifischen Ereignisverbrauchswerte (14a-14e) gemäß den umgebenden physikalischen Bedingungen anzupassen.

5. Funkkommunikationsgerät, das ein Batteriemanagementsystem nach einem der Ansprüche 1 bis 4 umfasst.

## Revendications

1. Système de gestion de batterie conçu pour fournir des informations sur le niveau de batterie d'un dispositif (4), comportant une mémoire non volatile (10), la mémoire non volatile (10) étant conçue pour conserver un compteur (12) de durée de vie globale prédéterminée et étant reliée à une unité (20) de surveillance d'évènements, **caractérisé en ce que** l'unité de surveillance d'évènements comporte une pluralité de compteurs d'évènements liés à chaque activité d'application dudit dispositif (4), ladite unité (20) de surveillance d'évènements étant conçue pour décrémenter le compteur (12) de durée de vie globale d'une valeur (14a à 14e) de consommation d'évènement spécifique pour chaque évènement correspondant à une activité d'application du dispositif (4).

2. Système de gestion de batterie selon la revendication 1, dans lequel les compteurs d'évènements sont incrémentés après détection d'un évènement lié.

3. Système de gestion de batterie selon la revendication 1 ou 2, dans lequel l'unité (20) de surveillance d'évènements est reliée à un dispositif de communication (24) conçu pour émettre une trame radio d'alerte lorsque le compteur (12) de durée de vie globale devient inférieur à une norme critique (16).

4. Système de gestion de batterie selon l'une quelconque des revendications 1 à 3, **caractérisé en ce qu'**il comporte un dispositif de détection (22) relié à l'unité (20) de surveillance d'évènements afin d'adapter les valeurs (14a à 14e) de consommation d'évènements spécifiques en fonction des conditions physiques ambiantes.

5. Dispositif de communication radio comportant un système de gestion de batterie selon l'une quelconque des revendications 1 à 4.
